# EUROPÄISCHE PATENTSCHRIFT

(11) **EP 3 651 360 B1**
(45) Veröffentlichungstag und Bekanntmachung des Hinweises auf die Patenterteilung: **08.01.2025**
(21) Anmeldenummer: 18465613.0
(22) Anmeldetag: 08.11.2018
(51) Int. Cl.: H03K 17/12, H03K 17/16

(54) **VERFAHREN ZUM SCHALTEN EINES ZYKLUS IN EINER LEISTUNGSTRANSISTORSCHALTUNG**
METHOD FOR SWITCHING A CYCLE IN A POWER TRANSISTOR CIRCUIT
PROCÉDÉ DE COMMUTATION D'UN CYCLE DANS UN CIRCUIT DE TRANSISTOR DE PUISSANCE

(43) Veröffentlichungstag der Anmeldung: 13.05.2020
(73) Patentinhaber: Vitesco Technologies Germany GmbH, 93055 Regensburg (DE)
(72) Erfinder: Loerincz, Robert Istvan, 300414 Timisoara (RO); Antongirolami, Diego, 90429 Nürnberg (DE); Arabackyj, Marc, 90408 Nürnberg (DE); Katzmann, Johannes, 93059 Regensburg (DE)
(74) Vertreter: Vitesco Technologies

(56) Entgegenhaltungen:
- EP-A1- 2 587 670
- US-A1- 2016 218 621

## Beschreibung

Leistungstransistoren finden unter anderem in elektronischen Vorschaltgeräten und in Transformatoren Anwendung. Leistungstransistoren sind eingerichtet, große Ströme zu schalten und/oder zu steuern. Treten größere Ströme auf, als ein einzelner Leistungstransistor schalten kann, so wird der Strom in einer Schaltung typischerweise auf mehrere Leistungstransistoren verteilt. Bei einer Parallelschaltung von Leistungstransistoren kann sich bauteilbedingt das Problem einer unsymmetrischen Erhitzung eines einzelnen der parallel geschalteten Leistungstransistoren ergeben, da typischerweise die einzelnen Leistungstransistoren zumindest leicht unterschiedliche Eigenschaften aufweisen und es somit zu Verlusten, bestehend aus Schaltverlusten und Leitungsverlusten, in unterschiedlicher Höhe kommt. Beim Schalten des Leistungstransistors in einen leitenden Zustand kommt es zu Schaltverlusten, wodurch sich der Leistungstransistor erwärmt. Eine solche Erwärmung des Leistungstransistors führt einerseits zu einer Erhöhung der Leitungsverluste und andererseits zu einem Absinken einer Threshold-Spannung, ab welcher der Leistungstransistor Strom leitet.

In einer Parallelschaltung von mehreren Leistungstransistoren weist einer der Leistungstransistoren üblicherweise bedingt durch Bauteilestreuungen die niedrigste Threshold-Spannung auf. Als Folge trägt dieser Leistungstransistor nahezu die gesamten Schaltverluste der Schaltung. Es kommt somit zu einer unsymmetrischen Verteilung von Schaltverlusten und damit zu einer unsymmetrischen Erhitzung über die Schaltung.

Bekannte Lösungsansätze für das Problem der asymmetrischen Erhitzung sind das schnelle Schalten der Leistungstransistoren, wobei die parasitären induktiven Eigenschaften zu einer gewissen Symmetrisierung der Schaltverluste führen.

Alternativ werden Leistungstransistoren verwendet, welche auf besondere Gleichheit ihrer Eigenschaften bzw. Kennwerte selektiert sind und welche somit eine geringe Streuung der Kennwerte aufweisen, jedoch aufgrund des hierfür notwendigen Selektionsaufwands teuer sind.

Die DE 10 2013 220 842 A1 offenbart ein Verfahren zum Schalten eines Zyklus in einer Leistungstransistorschaltung, insbesondere in einer Parallelschaltung von Leistungstransistoren. Das Verfahren weist das Vorgeben einer Schaltzeitdifferenz auf, sowie das Schalten der Leistungstransistoren zu zwei Schaltzeitpunkten, welche mittels der Schaltzeitdifferenz voneinander getrennt sind.

Die EP 2 587 670 A1 offenbart ein Verfahren zum Schalten eines Zyklus in einer Leistungstransistorschaltung nach dem Oberbegriff des Anspruchs 1.

Aufgabe der vorliegenden Erfindung ist es, ein verbessertes Verfahren zum Schalten eines Zyklus in einer Leistungstransistorschaltung anzugeben.

Die Aufgabe wird erfindungsgemäß gelöst durch ein Verfahren mit den Merkmalen des Anspruchs 1.

Vorteilhafte Weiterbildungen sind Gegenstand der abhängigen Ansprüche.

Bei einem erfindungsgemäßen Verfahren zum Schalten eines Zyklus in einer Leistungstransistorschaltung, welche mindestens zwei, beispielsweise drei, einander parallel geschaltete Leistungstransistoren, beispielsweise MOSFET oder IGBT, aufweist, wobei die Leistungstransistoren jeweils ein Gate aufweisen, werden die Gates mit mindestens drei voneinander und von Null verschiedenen Steuerwerten angesteuert. Bei einer Einschaltsequenz der parallel geschalteten Leistungstransistoren wird ein erster der Leistungstransistoren zunächst mit einem höheren Steuerwert angesteuert als der andere Leistungstransistor oder die anderen Leistungstransistoren, so dass eine Gatespannung des ersten Leistungstransistors eine Schwellspannung als erstes überschreitet, das heißt, bevor die Gatespannung des anderen Leistungstransistors oder der anderen Leistungstransistoren die Schwellspannung erreicht.

In einer Ausführungsform wird/werden der andere Leistungstransistor oder die anderen Leistungstransistoren mittels des verwendeten Steuerwertes so angesteuert, dass seine/ihre Gatespannung zumindest solange unterhalb der Schwellspannung bleibt bis die Gatespannung des ersten Leistungstransistors ein Millerplateau erreicht hat.

In einer Ausführungsform wird bei einer Ausschaltsequenz der parallel geschalteten Leistungstransistoren ein erster der Leistungstransistoren zunächst mit einem niedrigeren Steuerwert angesteuert als der andere Leistungstransistor oder die anderen Leistungstransistoren, so dass eine Gatespannung des ersten Leistungstransistors ein Millerplateau als letztes erreicht, das heißt, nachdem die Gatespannung des anderen Leistungstransistors oder der anderen Leistungstransistoren das Millerplateau erreicht oder unterschritten haben.

In einer Ausführungsform wird als Steuerwert ein Gatestrom oder eine Gatespannungsänderungsrate verwendet.

In einer Ausführungsform werden die einander parallel geschalteten Leistungstransistoren über aufeinanderfolgende Pulsweitenmodulationstaktperioden in der Einschaltsequenz alternierend als erster Leistungstransistor zunächst mit einem höheren Steuerwert angesteuert und/oder in der Ausschaltsequenz alternierend als erster Leistungstransistor zunächst mit einem niedrigeren Steuerwert angesteuert.

In einer Ausführungsform wird innerhalb jeweils einer der Pulsweitenmodulationstaktperioden einer der Leistungstransistoren sowohl in der Einschaltsequenz als erster Leistungstransistor zunächst mit einem höheren Steuerwert angesteuert als auch in der Ausschaltsequenz als erster Leistungstransistor zunächst mit einem niedrigeren Steuerwert angesteuert.

In einer Ausführungsform wird innerhalb jeweils einer der Pulsweitenmodulationstaktperioden einer der Leistungstransistoren in der Einschaltsequenz als erster Leistungstransistor zunächst mit einem höheren Steuerwert angesteuert und in der Ausschaltsequenz wird ein anderer der Leistungstransistoren als erster Leistungstransistor zunächst mit einem niedrigeren Steuerwert angesteuert.

In einer Ausführungsform wird in der Einschaltsequenz bei Überschreiten eines vorgegebenen Wertes und bis zum Erreichen des Millerplateaus durch die Gatespannung des ersten Leistungstransistors der erste Leistungstransistor mit einem niedrigeren Steuerwert angesteuert als der andere Leistungstransistor oder die anderen Leistungstransistoren, wobei die Steuerwerte aller einander parallel geschalteten Leistungstransistoren anschließend angehoben werden.

In einer Ausführungsform wird in der Ausschaltsequenz bei oder kurz vor dem Abfall der Gatespannung des anderen Leistungstransistors oder der anderen Leistungstransistoren auf Null die Gatespannung des ersten Leistungstransistors auf einen niedrigeren Steuerwert abgesenkt und die Gatespannung des anderen Leistungstransistors oder der anderen Leistungstransistoren wird auf Null abgesenkt.

In einer Ausführungsform erfolgt die Ansteuerung der Gates mittels eines ASIC. Beispielsweise enthält der ASIC Treiberschaltungen entsprechend der in WO 2014/173969 A1 beschriebenen Steuerungsvorrichtung und dem dafür beschriebenen Verfahren, insbesondere gemäß den Figuren 1 und 3 bis 18 und der Beschreibung auf Seiten 8 bis 26. Die WO 2014/173969 A1 wird hiermit vollumfänglich durch Verweis in die vorliegende Patentanmeldung einbezogen.

Mittels des erfindungsgemäßen Verfahrens gelingt es, die Schaltverluste zwischen einander parallel geschalteten Leistungstransistoren zu symmetrisieren und gleichzeitig Schaltzeiten zu verringern. Durch die gleichförmige Leistungsverlust-Verteilung über die einander parallel geschalteten Leistungstransistoren wird der maximale Leistungsverlust für jeden der Leistungstransistoren reduziert.

Ausführungsbeispiele der Erfindung werden anhand von Zeichnungen näher erläutert. Dabei zeigen:
- Fig. 1: eine schematische Ansicht einer Brückenschaltung aus Leistungstransistoren mit einer Ansteuerung,
- Fig. 2: eine schematische Ansicht einer Halbbrücke aus Figur 1,
- Fig. 3: ein Diagramm mit Signalverläufen für einen Leistungstransistor während einer Einschaltsequenz,
- Fig. 4: ein Diagramm mit Signalverläufen für einen Leistungstransistor während einer Ausschaltsequenz,
- Fig. 5: ein Diagramm mit Signalverläufen für drei parallel geschaltete Leistungstransistoren während einer Einschaltsequenz, und
- Fig. 6: ein Diagramm mit Signalverläufen für drei parallel geschaltete Leistungstransistoren während einer Ausschaltsequenz.

Einander entsprechende Teile sind in allen Figuren mit den gleichen Bezugszeichen versehen.

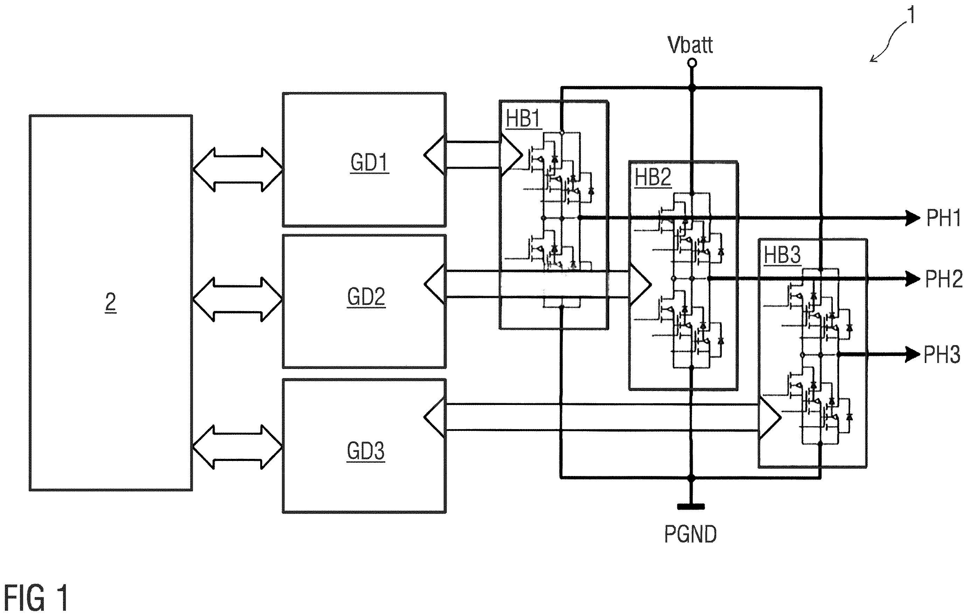

Figur 1 zeigt eine schematische Ansicht einer Brückenschaltung 1, beispielsweise für einen Leistungsinverter. Die Brückenschaltung 1 umfasst drei Halbbrücken HB1, HB2, HB3, die jeweils zwischen ein Batteriepotential Vbatt und ein Massepotential PGND geschaltet sind und jeweils ein Ausgangssignal PH1, PH2, PH3 aufweisen. Jede der Halbbrücken HB1, HB2, HB3 wird von je einer Treiberschaltung GD1, GD2, GD3 angesteuert, die von einem Steuergerät 2 gesteuert werden.

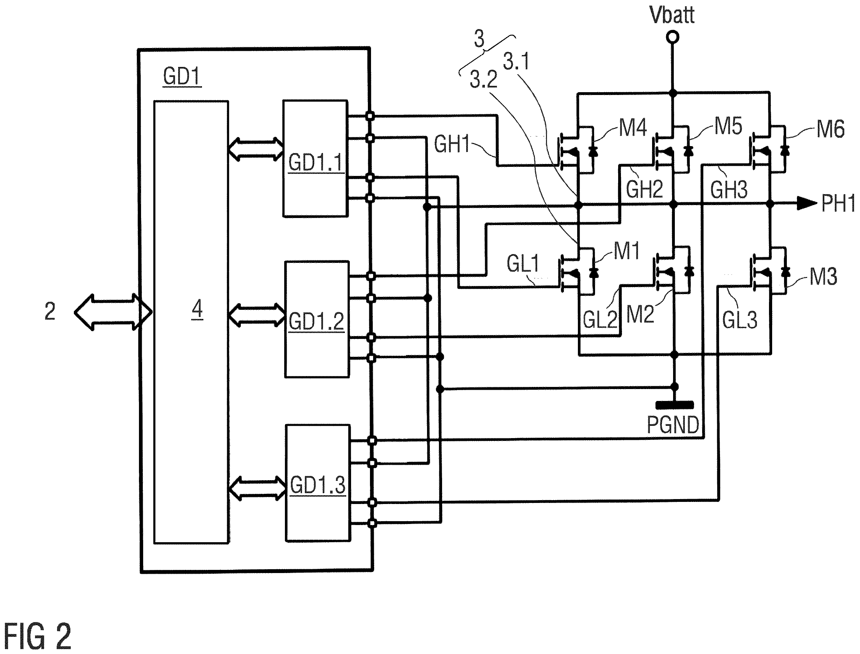

Figur 2 zeigt eine schematische Ansicht einer der Halbbrücken HB1 und der zugeordneten Treiberschaltung GD1 aus Figur 1. Die Halbbrücke HB1 weist drei zueinander parallel geschaltete Außenzweige 3 auf, die jeweils in Teilzweige 3.1, 3.2 unterteilt sind. In jedem Teilzweig 3.1, 3.2 jedes Außenzweiges 3 befindet sich ein elektronisches Bauelement M1, M2, M3, M4, M5, M6, das zur Ausgabe eines Ausgangssignals PH1 ausgebildet ist und dazu einen Steueranschluss GL1, GL2, GL3, GH1, GH2, GH3 aufweist.

Jedes der elektronischen Bauelemente M1, M2, M3, M4, M5, M6 ist in dem in Figur 2 dargestellten Ausführungsbeispiel als ein MOSFET (Metall-Oxid-Halbleiter-Feldeffekttransistor) ausgebildet. Das Steuersignal S steuert in diesem Fall einen Gatestrom Ig im Gate des MOSFET oder alternativ eine Gatespannungsänderungsrate Vg' (zeitliche Ableitung) einer Gatespannung Vg zwischen Gate und Source bzw. eines Gatepotentials am Gate des MOSFET.

Das Ausgangssignal PH1 ist in diesem Fall eine Drain-Source-Spannung zwischen Drain und Source des MOSFET.

Alternativ kann statt eines MOSFET auch ein IGBT (Bipolartransistor mit isolierter Gate-Elektrode) als elektronisches Bauelement mit entsprechendem Steuersignal und Ausgangssignal PH1 verwendet werden.

Über die Ausgangssignale PH1 der elektronischen Bauelemente M1, M2, M3, M4, M5, M6 werden ein elektrischer Strom durch eine elektrische Last und/oder eine an der elektrischen Last anliegende elektrische Spannung gesteuert. Dazu werden die elektronischen Bauelemente M1, M2, M3, M4, M5, M6 mittels einer Pulsweitenmodulation PWM ein und abgeschaltet.

Jedes der elektronischen Bauelemente M1, M2, M3, M4, M5, M6 ist mit der Treiberschaltung GD1 verbunden, die als ein ASIC ausgebildet sein kann. Innerhalb der Treiberschaltung GD1 sind Treibereinheiten GD1.1, GD1.2, GD1.3 zum Ansteuern jeweils eines der Außenzweige 3 vorgesehen. Eine Steuerlogik 4 steuert die Treibereinheiten GD1.1, GD1.2, GD1.3 an. Die Treiberschaltungen GD1, GD2, GD3 können so ausgebildet sein, dass sie jeweils sechs konfigurierbare Konstantstromquellen umfassen, mittels denen jeweils mindestens drei verschiedene Konstantstromniveaus für jedes einzelne der elektronischen Bauelemente M1, M2, M3, M4, M5, M6 eingestellt werden können. Beispielsweise sind die Treiberschaltungen GD1, GD2, GD3 entsprechend der in WO 2014/173969 A1 beschriebenen Steuerungsvorrichtung und dem dafür beschriebenen Verfahren ausgebildet, insbesondere gemäß den Figuren 1 und 3 bis 18 und der Beschreibung auf Seiten 8 bis 26.

Beim Schalten dreier parallel geschalteter elektronischer Bauelemente M1, M2, M3, M4, M5, M6, beispielsweise MOSFETS oder IGBT, wird eine gleichförmige Leistungsableitungs-Verteilung über die parallelen elektronischen Bauelemente M1, M2, M3, M4, M5, M6 angestrebt. Infolge von Bauteiltoleranzen schalten die elektronischen Bauelemente M1, M2, M3, M4, M5, M6 nicht gleichzeitig. Eines der drei elektronischen Bauelemente M1, M2, M3, M4, M5, M6 schaltet stets schneller als die anderen und muss daher die Schaltverluste allein tragen, so dass die Leistungsableitungs-Verteilung über die parallelen elektronischen Bauelemente M1, M2, M3, M4, M5, M6 ungleichförmig wird.

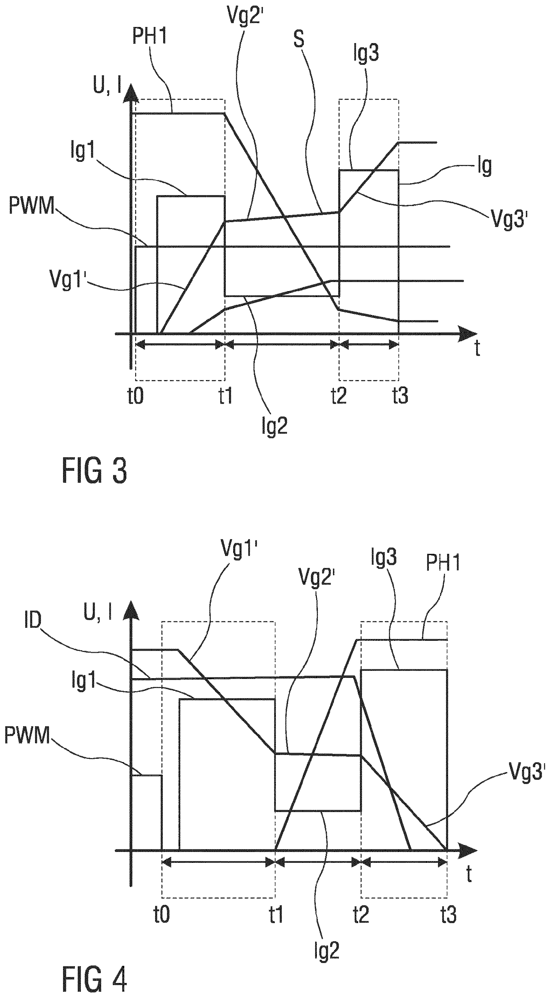

Figur 3 ist ein Diagramm mit Signalverläufen für ein elektronisches Bauelement M1, M2, M3, M4, M5, M6, beispielsweise einen Leistungstransistor, insbesondere ein MOSFET oder IGBT während einer Einschaltsequenz.

In einer ersten Ausführungsvariante steuert ein Steuersignal S den Gatestrom Ig. Für das Einschalten des elektronischen Bauelements M1, M2, M3, M4, M5, M6 werden ein erster Steuerwert Ig1, ein zweiter Steuerwert Ig2 und ein dritter Steuerwert Ig3 für den Gatestrom Ig vorgegeben. Nach einem Pegelwechselzeitpunkt t0 wird der Gatestrom Ig zunächst von Null auf den ersten Steuerwert Ig1 gesteuert. Danach wird der Gatestrom Ig bis zu einem ersten Umschaltzeitpunkt t1 auf dem ersten Steuerwert Ig1 gehalten. Zu dem ersten Umschaltzeitpunkt t1 wird der Gatestrom Ig auf den zweiten Steuerwert Ig2 gesteuert. Danach wird der Gatestrom Ig bis zu einem zweiten Umschaltzeitpunkt t2 auf dem zweiten Steuerwert Ig2 gehalten. Zu dem zweiten Umschaltzeitpunkt t2 wird der Gatestrom Ig auf den dritten Steuerwert Ig3 gesteuert. Danach wird der Gatestrom Ig solange auf dem dritten Steuerwert Ig3 gehalten, bis die Gatespannung Vg zu einem Endwertzeitpunkt t3 einen Gatespannungsendwert erreicht. Danach fällt der Gatestrom Ig auf Null ab.

Die Steuerwerte Ig1, Ig2, Ig3 können dabei in Abhängigkeit von den Eigenschaften der Brückenschaltung 1 geeignet vorgegeben werden, so dass sie eine Reduzierung der Oszillationen des Ausgabesignals ermöglichen. Beispielsweise werden sie so gewählt, dass Ig2 < Ig1 < Ig3 ist.

In einer zweiten Ausführungsvariante steuert das Steuersignal S die Gatespannungsänderungsrate Vg'. Analog zur ersten Ausführungsvariante werden ein erster Steuerwert Vg1', ein zweiter Steuerwert Vg2' und ein dritter Steuerwert Vg3' der Gatespannungsänderungsrate Vg' vorgegeben. Diese drei Steuerwerte Vg1`, Vg2', Vg3' werden analog zu den Steuerwerten Ig1, lg2, Ig3 der ersten Ausführungsvariante zur Ansteuerung des elektronischen Bauelements M1, M2, M3, M4, M5, M6 verwendet, d.h. die Gatespannung Vg wird zwischen dem Pegelwechselzeitpunkt t0 und einem ersten Umschaltzeitpunkt t1 mit dem ersten Steuerwert Vg1', zwischen dem ersten Umschaltzeitpunkt t1 und einem zweiten Umschaltzeitpunkt t2 mit dem zweiten Steuerwert Vg2' und von dem zweiten Umschaltzeitpunkt t2 bis zum Erreichen eines Gatespannungsendwertes mit dem dritten Steuerwert Vg3' geändert.

Die Umschaltzeitpunkte t1, t2 können in beiden Ausführungsvarianten in Abhängigkeit von einer erfassten Amplitudengröße derart bestimmt werden, dass die Schwingungsamplituden des Ausgangssignals PH1 begrenzt werden. Dabei werden zur Bestimmung des ersten Umschaltzeitpunktes tl die Schwingungsamplituden während eines ersten Zeitfensters, das sich von dem Pegelwechselzeitpunkt t0 bis zum zweiten Umschaltzeitpunkt t2 erstreckt, und zur Bestimmung des zweiten Umschaltzeitpunktes t2 die Schwingungsamplituden während eines zweiten Zeitfensters, das sich von dem zweiten Umschaltzeitpunkt t2 bis zum Endwertzeitpunkt t3 erstreckt, zu jeweils einer Amplitudengröße ausgewertet. Die jeweiligen Amplitudengrößen werden während jeder PWM -Taktperiode erfasst und zur Bestimmung der Umschaltzeitpunkte t1, t2 der darauffolgenden Taktperiode verwendet, um die Schwingungsamplituden zu begrenzen. Für die Umschaltzeitpunkte t1, t2 können ferner zwei Grenzwerte vorgegeben und die Umschaltzeitpunkte t1, t2 derart bestimmt werden, dass der erste Umschaltzeitpunkt t1 einen ersten Grenzwert nicht unterschreitet und der zweite Umschaltzeitpunkt t2 den zweiten Grenzwert nicht überschreitet. Der erste Grenzwert gibt somit eine untere Grenze für den ersten Umschaltzeitpunkt t1 an und der zweite Grenzwert gibt eine obere Grenze für den zweiten Umschaltzeitpunkt t2 an. Die Grenzwerte können derart vorgegeben werden, dass ein Einschalten des elektronischen Bauelements M1, M2, M3, M4, M5, M6 nicht durch einen zu kleinen ersten Umschaltzeitpunkt t1 oder einen zu großen zweiten Umschaltzeitpunkt t2 verhindert wird.

In einer Ausführungsform wird in einer ersten Pulsweitenmodulationstaktperiode beim Einschalten der mit Massepotential PGND verbundenen elektronischen Bauelemente M1, M2, M3 der Teilzweige 3.1 das elektronische Bauelement M1 so konfiguriert, dass es während der Periode von t0 bis t1 einen größeren Steuerwert Vg1`, Vg2', Vg3' oder Ig1, lg2, Ig3 aufweist als die elektronischen Bauelemente M2 und M3. Auf diese Weise wird sichergestellt, dass das elektronische Bauelement M1 alle Schaltverluste trägt. In einer anschließenden Pulsweitenmodulationstaktperiode wird beim Einschalten der mit Massepotential PGND verbundenen elektronischen Bauelemente M1, M2, M3 das elektronische Bauelement M2 so konfiguriert, dass es während der Periode von t0 bis t1 einen größeren Steuerwert Vg1', Vg2', Vg3' oder Ig1, lg2, Ig3 aufweist als die elektronischen Bauelemente M1 und M3. Auf diese Weise wird sichergestellt, dass das elektronische Bauelement M2 alle Schaltverluste trägt. In einer anschließenden Pulsweitenmodulationstaktperiode wird beim Einschalten der mit Massepotential PGND verbundenen elektronischen Bauelemente M1, M2, M3 das elektronische Bauelement M3 so konfiguriert, dass es während der Periode von t0 bis t1 einen größeren Steuerwert Vg1', Vg2', Vg3' oder Ig1, lg2, Ig3 aufweist als die elektronischen Bauelemente M1 und M2. Auf diese Weise wird sichergestellt, dass das elektronische Bauelement M3 alle Schaltverluste trägt. Dasselbe Verfahren wird beim Einschalten der mit dem Batteriepotential Vbatt verbundenen elektronischen Bauelemente M4, M5, M6 in den Teilzweigen 3.2 angewandt. In jeder Pulsweitenmodulationstaktperiode ändert sich das elektronische Bauelement M1, M2, M3, M4, M5, M6, das zuerst eingeschaltet wird infolge der beschriebenen Ansteuerung durch die Treiberschaltung GD1, GD2, GD3.

Um den gesamten Laststrom I_LOAD im jeweils zuerst eingeschalteten elektronischen Bauelement M1, M2, M3, M4, M5, M6 der Teilzweige 3.1 oder 3.2 zu halten, werden die jeweiligen beiden anderen elektronischen Bauelemente M1, M2, M3, M4, M5, M6 solange unterhalb ihrer Schwellspannung V_TH gehalten bis das zuerst eingeschaltete elektronische Bauelement M1, M2, M3, M4, M5, M6 sein Millerplateau Vg_PLAT erreicht.

Figur 4 zeigt ein Diagramm mit Signalverläufen für ein elektronisches Bauelement M1, M2, M3, M4, M5, M6, beispielsweise einen Leistungstransistor, insbesondere einen MOSFET oder IGBT während einer Ausschaltsequenz.

In einer ersten Ausführungsvariante steuert ein Steuersignal S den Gatestrom Ig. Für das Ausschalten des elektronischen Bauelements M1, M2, M3, M4, M5, M6 werden ein erster Steuerwert Ig1, ein zweiter Steuerwert Ig2 und ein dritter Steuerwert Ig3 für den Gatestrom Ig vorgegeben. Nach einem Pegelwechselzeitpunkt t0 wird der Gatestrom Ig zunächst von Null auf den ersten Steuerwert Ig1 gesteuert. Danach wird der Gatestrom Ig bis zu einem ersten Umschaltzeitpunkt t1 auf dem ersten Steuerwert Ig1 gehalten. Zu dem ersten Umschaltzeitpunkt t1 wird der Gatestrom Ig auf den zweiten Steuerwert Ig2 gesteuert. Danach wird der Gatestrom Ig bis zu einem zweiten Umschaltzeitpunkt t2 auf dem zweiten Steuerwert Ig2 gehalten. Zu dem zweiten Umschaltzeitpunkt t2 wird der Gatestrom Ig auf den dritten Steuerwert Ig3 gesteuert. Danach wird der Gatestrom Ig solange auf dem dritten Steuerwert Ig3 gehalten bis die Gatespannung Vg zu einem Endwertzeitpunkt t3 einen Gatespannungsendwert erreicht. Danach fällt der Gatestrom Ig auf Null ab.

Die Steuerwerte Ig1, lg2, Ig3 können dabei in Abhängigkeit von den Eigenschaften der Brückenschaltung 1 geeignet vorgegeben werden, so dass sie eine Reduzierung der Oszillationen des Ausgabesignals ermöglichen. Beispielsweise werden sie so gewählt, dass Ig2 < Ig1 < Ig3 ist.

In einer zweiten Ausführungsvariante steuert das Steuersignal S die Gatespannungsänderungsrate Vg'. Analog zur ersten Ausführungsvariante werden ein erster Steuerwert Vg1' ein zweiter Steuerwert Vg2' und ein dritter Steuerwert Vg3' der Gatespannungsänderungsrate Vg' vorgegeben. Diese drei Steuerwerte Vg1', Vg2', Vg3' werden analog zu den Steuerwerten Ig1, lg2, Ig3 der ersten Ausführungsvariante zur Ansteuerung des elektronischen Bauelements M1, M2, M3, M4, M5, M6 verwendet, d.h. die Gatespannung Vg wird zwischen dem Pegelwechselzeitpunkt t0 und einem ersten Umschaltzeitpunkt t1 mit dem ersten Steuerwert Vg1', zwischen dem ersten Umschaltzeitpunkt t1 und einem zweiten Umschaltzeitpunkt t2 mit dem zweiten Steuerwert Vg2' und von dem zweiten Umschaltzeitpunkt t2 bis zum Erreichen eines Gatespannungsendwertes mit dem dritten Steuerwert Vg3' geändert.

Die Umschaltzeitpunkte t1, t2 können in beiden Ausführungsvarianten in Abhängigkeit von einer erfassten Amplitudengröße derart bestimmt werden, dass die Schwingungsamplituden des Ausgangssignals PH1 begrenzt werden. Dabei werden zur Bestimmung des ersten Umschaltzeitpunktes t1 die Schwingungsamplituden während eines ersten Zeitfensters, das sich von dem Pegelwechselzeitpunkt t0 bis zum zweiten Umschaltzeitpunkt t2 erstreckt, und zur Bestimmung des zweiten Umschaltzeitpunktes t2 die Schwingungsamplituden während eines zweiten Zeitfensters, das sich von dem zweiten Umschaltzeitpunkt t2 bis zum Endwertzeitpunkt t3 erstreckt, zu jeweils einer Amplitudengröße ausgewertet. Die jeweiligen Amplitudengrößen werden während jeder PWM -Taktperiode erfasst und zur Bestimmung der Umschaltzeitpunkte t1, t2 der darauffolgenden Taktperiode verwendet, um die Schwingungsamplituden zu begrenzen. Für die Umschaltzeitpunkte t1, t2 können ferner zwei Grenzwerte vorgegeben und die Umschaltzeitpunkte t1, t2 derart bestimmt werden, dass der erste Umschaltzeitpunkt t1 einen ersten Grenzwert nicht unterschreitet und der zweite Umschaltzeitpunkt t2 den zweiten Grenzwert nicht überschreitet. Der erste Grenzwert gibt somit eine untere Grenze für den ersten Umschaltzeitpunkt t1 an und der zweite Grenzwert gibt eine obere Grenze für den zweiten Umschaltzeitpunkt t2 an. Die Grenzwerte können derart vorgegeben werden, dass ein Einschalten des elektronischen Bauelements M1, M2, M3, M4, M5, M6 nicht durch einen zu kleinen ersten Umschaltzeitpunkt t1 oder einen zu großen zweiten Umschaltzeitpunkt t2 verhindert wird.

Beim Ausschalten der parallel geschalteten elektronischen Bauelemente M1, M2, M3, M4, M5, M6 wird die Reihenfolge des Abschaltens gegenüber dem Einschalten umgekehrt.

Beispielsweise wird in einer ersten Pulsweitenmodulationstaktperiode beim Ausschalten der mit Massepotential PGND verbundenen elektronischen Bauelemente M1, M2, M3 der Teilzweige 3.1 das elektronische Bauelement M1 so konfiguriert, dass es nach den elektronischen Bauelementen M2 und M3 abgeschaltet wird. Auf diese Weise wird sichergestellt, dass das elektronische Bauelement M1 alle Schaltverluste trägt. In einer anschließenden Pulsweitenmodulationstaktperiode wird beim Ausschalten der mit Massepotential PGND verbundenen elektronischen Bauelemente M1, M2, M3 das elektronische Bauelement M2 so konfiguriert, dass es nach den elektronischen Bauelementen M1 und M3 abgeschaltet wird. Auf diese Weise wird sichergestellt, dass das elektronische Bauelement M2 alle Schaltverluste trägt. In einer anschließenden Pulsweitenmodulationstaktperiode wird beim Ausschalten der mit Massepotential PGND verbundenen elektronischen Bauelemente M1, M2, M3 das elektronische Bauelement M3 so konfiguriert, dass es nach den elektronischen Bauelementen M1 und M2 abgeschaltet wird. Auf diese Weise wird sichergestellt, dass das elektronische Bauelement M3 alle Schaltverluste trägt. Dasselbe Verfahren wird beim Ausschalten der mit dem Batteriepotential Vbatt verbundenen elektronischen Bauelemente M4, M5, M6 in den Teilzweigen 3.2 angewandt. In jeder Pulsweitenmodulationstaktperiode ändert sich das elektronische Bauelement M1, M2, M3, M4, M5, M6, das zuletzt abgeschaltet wird infolge der beschriebenen Ansteuerung durch die Treiberschaltung GD1, GD2, GD3.

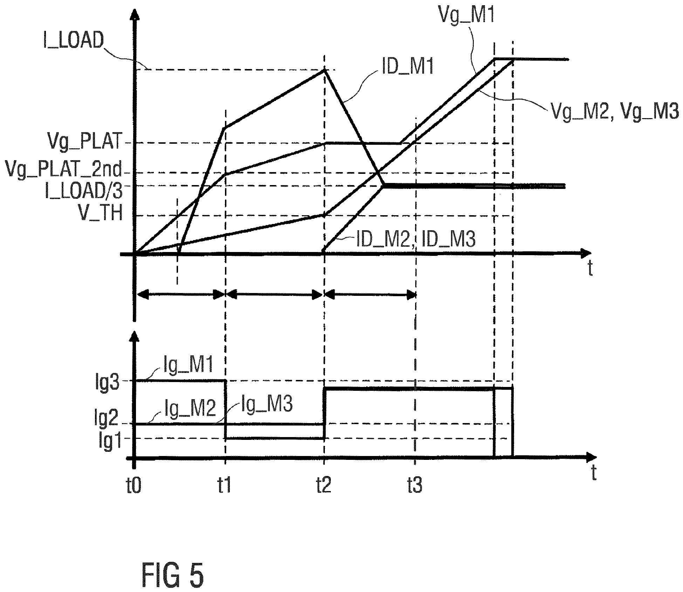

Figur 5 zeigt ein Diagramm mit Signalverläufen für drei parallel geschaltete elektronische Bauelemente M1, M2, M3, M4, M5, M6, beispielsweise Leistungstransistoren, insbesondere MOSFET oder IGBT Leistungstransistoren während einer Einschaltsequenz.

Nach einem Pegelwechselzeitpunkt t0 wird der Gatestrom Ig_M1 des elektronischen Bauelements M1 von Null auf den dritten Steuerwert Ig3 gesteuert, während der Gatestrom lg_M2, lg_M3 der elektronischen Bauelemente M2 und M3 jeweils von Null auf den zweite Steuerwert Ig2 gesteuert wird, der niedriger als der dritte Steuerwert Ig3 ist. Die Gateströme Ig_M1, Ig_M2, Ig_M3 werden bis zu einem ersten Umschaltzeitpunkt t1 auf dem jeweiligen Wert gehalten. Infolgedessen steigt die Gatespannung Vg_M1 des elektronischen Bauelements M1 bis zum ersten Umschaltzeitpunkt t1 stärker an als die Gatespannungen Vg_M2 und Vg_M3 der elektronischen Bauelemente M2 und M3. Dabei übersteigt die Gatespannung Vg_M1 zunächst die Schwellspannung V_TH des elektronischen Bauelements M1, so dass ein Drainstrom ID_M1 über das elektronische Bauelement M1 zu fließen beginnt und ansteigt. Zum ersten Umschaltzeitpunkt t1 erreicht die Gatespannung Vg_M1 des elektronischen Bauelements M1 einen Wert Vg_PLAT_2ND, während die Gatespannungen Vg_M2, Vg_M3 der elektronischen Bauelemente M2, M3 noch unterhalb der Schwellspannung V_TH verbleiben.

Zum ersten Umschaltzeitpunkt t1 wird der Gatestrom Ig_M1 des elektronischen Bauelements M1 auf den ersten Steuerwert Ig1 abgesenkt, während der Gatestrom lg_M2, Ig_M3 der elektronischen Bauelemente M2 und M3 auf dem zweiten Steuerwert Ig2 gehalten wird. Die Gateströme Ig_M1, Ig_M2, Ig_M3 werden bis zu einem zweiten Umschaltzeitpunkt t2 auf dem jeweiligen Wert gehalten. Infolgedessen steigen die Gatespannungen Vg_M1, Vg_M2, Vg_M3 der elektronischen Bauelemente M1, M2, M3 bis zum zweiten Umschaltzeitpunkt t2 weiter an, so dass der Drainstrom ID_M1 über das elektronische Bauelement M1 weiter ansteigt. Zum zweiten Umschaltzeitpunkt t2 erreicht die Gatespannung Vg_M1 des elektronischen Bauelements M1 das Millerplateau Vg_PLAT und die Gatespannungen Vg_M2, Vg_M3 der elektronischen Bauelemente M2 und M3 erreichen die Schwellspannung V_TH, so dass ein Drainstrom ID_M2, ID_M3 über die elektronischen Bauelemente M2 und M3 zu fließen beginnt.

Zum zweiten Umschaltzeitpunkt t2 wird der Gatestrom Ig_M1, Ig_M2, Ig_M3 der elektronischen Bauelemente M1 auf den dritten Steuerwert Ig3 oder leicht darunter angehoben. Die Drainströme ID_M2, ID_M3 der elektronischen Bauelemente M2 und M3 steigen infolgedessen stark an und entlasten das elektronische Bauelement M1, dessen Drainstrom ID_M1 abfällt, bis jeder der Drainströme ID_M1, ID_M2, ID_M3 ein Drittel des Laststroms I_LOAD beträgt.

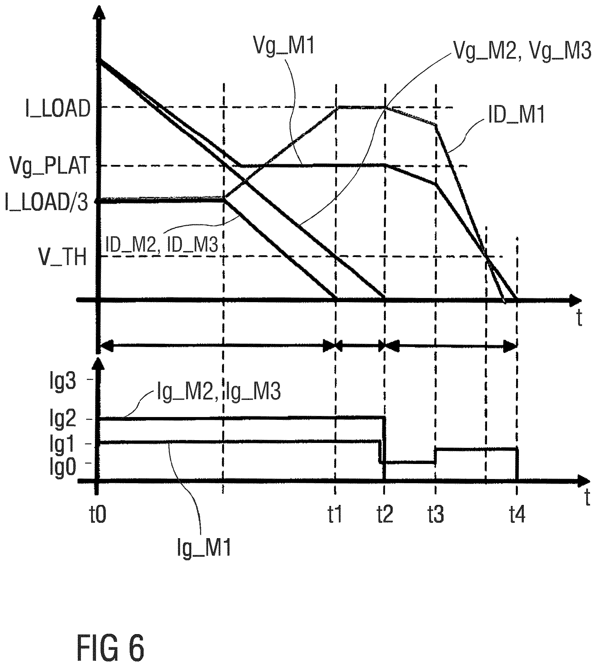

Figur 6 zeigt ein Diagramm mit Signalverläufen für drei parallel geschaltete elektronische Bauelemente M1, M2, M3, M4, M5, M6, beispielsweise Leistungstransistoren, insbesondere MOSFET oder IGBT Leistungstransistoren während einer Ausschaltsequenz.

Zu einem Pegelwechselzeitpunkt t0 wird der Gatestrom Ig_M1 des elektronischen Bauelements M1 vom dritten Steuerwert Ig3 auf den ersten Steuerwert Ig1 abgesenkt, während der Gatestrom lg_M2, Ig_M3 der elektronischen Bauelemente M2 und M3 jeweils vom dritten Steuerwert Ig3 auf den zweiten Steuerwert Ig2 abgesenkt wird, der höher als der erste Steuerwert Ig1 ist. Infolgedessen sinken die Gatespannungen Vg_M1, Vg_M2, Vg_M3 der elektronischen Bauelemente M1, M2, M3 bis zum Erreichen des Millerplateaus Vg_PLAT ab, wobei die Gatespannung Vg_M1 das Millerplateau Vg_PLAT etwas später erreicht als die Gatespannungen Vg_M2, Vg_M3. Nach dem Unterschreiten des Millerplateaus Vg_PLAT fallen die Gatespannungen Vg_M2, Vg_M3 bis zum ersten Umschaltzeitpunkt t1 weiter bis auf die Schwellspannung V_TH ab, wodurch gleichzeitig die Drainströme ID_M2, ID_M3 der elektronischen Bauelemente M2, M3 bis auf Null abfallen. Die Gatespannung Vg_M1 des elektronischen Bauelements M1 verbleibt hingegen auf dem Millerplateau Vg_PLAT, so dass das elektronische Bauelement M1 durchgesteuert bleibt und der Drainstrom ID_M1 infolge des Abfallens der Drainströme ID_M2, ID_M3 bis zum Erreichen des Laststroms I_LOAD ansteigt.

Bis zum zweiten Umschaltzeitpunkt t2 verbleiben die Gateströme Ig_M1, Ig_M2, Ig_M3 auf ihren Werten und die Gatespannungen Vg_M2 und Vg_M3 der elektronischen Bauelemente M2 und M3 fallen infolgedessen bis auf Null ab, während die Gatespannung Vg_M1 des elektronischen Bauelements M1 auf dem Millerplateau Vg_PLAT verbleibt.

Zum zweiten Umschaltzeitpunkt t2 werden die Gateströme Ig_M2 und Ig_M3 auf Null abgesenkt und der Gatestrom Ig_M1 wird, gegebenenfalls bereits kurz vor dem Erreichen des zweiten Umschaltzeitpunkts t2, auf einen Steuerwert Ig0 abgesenkt, der größer als Null aber kleiner als der erste Steuerwert Ig1 ist. Infolgedessen fällt die Gatespannung Vg_M1 unter das Millerplateau Vg_PLAT und der Drainstrom ID_M1 verringert sich ebenfalls. Zum dritten Umschaltzeitpunkt t3 wird der Gatestrom Ig_M1 wieder auf den Steuerwert Ig1 angehoben. Infolgedessen fällt die Gatespannung Vg_M1 und der Drainstrom ID_M1 steiler bis auf den Wert Null ab.

Das dargestellte Verfahren kann so angewandt werden, dass in einer ersten Pulsweitenmodulationstaktperiode beim Einschalten der mit Massepotential PGND verbundenen elektronischen Bauelemente M1, M2, M3 der Teilzweige 3.1 das elektronische Bauelement M1 so konfiguriert wird, dass es vor den elektronischen Bauelementen M2 und M3 eingeschaltet wird. Auf diese Weise wird sichergestellt, dass das elektronische Bauelement M1 alle Schaltverluste trägt. In einer anschließenden Pulsweitenmodulationstaktperiode wird beim Einschalten der mit Massepotential PGND verbundenen elektronischen Bauelemente M1, M2, M3 das elektronische Bauelement M2 so konfiguriert, dass es vor den elektronischen Bauelementen M1 und M3 eingeschaltet wird. Auf diese Weise wird sichergestellt, dass das elektronische Bauelement M2 alle Schaltverluste trägt. In einer anschließenden Pulsweitenmodulationstaktperiode wird beim Einschalten der mit Massepotential PGND verbundenen elektronischen Bauelemente M1, M2, M3 das elektronische Bauelement M3 so konfiguriert, dass es vor den elektronischen Bauelementen M1 und M2 eingeschaltet wird. Auf diese Weise wird sichergestellt, dass das elektronische Bauelement M3 alle Schaltverluste trägt. Dasselbe Verfahren wird beim Einschalten der mit dem Batteriepotential Vbatt verbundenen elektronischen Bauelemente M4, M5, M6 in den Teilzweigen 3.2 angewandt. In jeder Pulsweitenmodulationstaktperiode ändert sich das elektronische Bauelement M1, M2, M3, M4, M5, M6, das zuerst eingeschaltet wird infolge der beschriebenen Ansteuerung durch die Treiberschaltung GD1, GD2, GD3. In gleicher Weise werden die elektronischen Bauelemente M1, M2, M3, M4, M5, M6 beim Ausschalten alternierend als letztes ausgeschaltet. Dabei kann in jeder Pulsweitenmodulationstaktperiode das gleiche elektronische Bauelement M1, M2, M3, M4, M5, M6 als erstes eingeschaltet und als letztes ausgeschaltet werden. Alternativ wird in jeder Pulsweitenmodulationstaktperiode eines der elektronischen Bauelemente M1, M2, M3, M4, M5, M6 als erstes eingeschaltet und ein anderes der elektronischen Bauelemente M1, M2, M3, M4, M5, M6 als letztes ausgeschaltet.

### Bezugszeichenliste

- 1: Brückenschaltung
- 2: Steuergerät
- 3: Außenzweig
- 3.1, 3.2: Teilzweig
- 4: Steuerlogik
- GD1, GD2, GD3: Treiberschaltung
- GD1.1, GD1.2, GD1.3: Treibereinheit
- GH1, GH2, GH3: Steueranschluss
- GL1, GL2, GL3: Steueranschluss
- HB1, HB2, HB3: Halbbrücke, Leistungstransistorschaltung
- ID_M1, ID_M2, ID_M3: Drainstrom
- Ig: Gatestrom
- Ig0: Steuerwert
- Ig1: erster Steuerwert
- Ig2: zweiter Steuerwert
- Ig3: dritter Steuerwert
- lg_M1, lg_M2, Ig_M3: Gatestrom
- I_LOAD: Laststrom
- M1 - M6: elektronisches Bauelement, Leistungstransistor
- PGND: Massepotential
- PH1, PH2, PH3: Ausgangssignal
- PWM: Pulsweitenmodulation
- S: Steuersignal
- t: Zeit
- t0: Pegelwechselzeitpunkt
- t1: erster Umschaltzeitpunkt
- t2: zweiter Umschaltzeitpunkt
- t3: dritter Umschaltzeitpunkt, Endwertzeitpunkt
- Vbatt: Batteriepotential
- Vg: Gatespannung
- Vg': Gatespannungsänderungsrate
- Vg1': erster Steuerwert
- Vg2': zweiter Steuerwert
- Vg3': dritter Steuerwert
- Vg_M1, Vg_M2, Vg_M3: Gatespannung
- Vg_PLAT: Millerplateau
- Vg_PLAT_2ND: Wert
- V_TH: Schwellspannung

## Patentansprüche

1. Verfahren zum Schalten eines Zyklus in einer Leistungstransistorschaltung (HB1, HB2, HB3), welche mindestens zwei einander parallel geschaltete Leistungstransistoren (M1, M2, M3, M4, M5, M6) aufweist, wobei die Leistungstransistoren (M1, M2, M3, M4, M5, M6) jeweils ein Gate aufweisen, die beim Verfahren mit mindestens drei voneinander und von Null verschiedenen Steuerwerten (lg1, Ig2, Ig3, Vg1', Vg2', Vg3') angesteuert werden, **dadurch gekennzeichnet dass** bei einer Einschaltsequenz der parallel geschalteten Leistungstransistoren (M1, M2, M3, M4, M5, M6) ein erster der Leistungstransistoren (M1, M2, M3, M4, M5, M6) zunächst mit einem höheren Steuerwert (lg1, Ig2, Ig3, Vg1', Vg2', Vg3') angesteuert wird als der andere Leistungstransistor (M1, M2, M3, M4, M5, M6) oder die anderen Leistungstransistoren (M1, M2, M3, M4, M5, M6), so dass eine Gatespannung (Vg) des ersten Leistungstransistors (M1, M2, M3, M4, M5, M6) eine Schwellspannung (V_TH) als erstes überschreitet, und dass die einander parallel geschalteten Leistungstransistoren (M1, M2, M3, M4, M5, M6) über aufeinanderfolgende Pulsweitenmodulationstaktperioden in der Einschaltsequenz alternierend als erster Leistungstransistor (M1, M2, M3, M4, M5, M6) zunächst mit einem höheren Steuerwert (lg1, lg2, Ig3, Vg1', Vg2', Vg3') angesteuert werden.

2. Verfahren nach Anspruch 1, wobei der andere Leistungstransistor (M1, M2, M3, M4, M5, M6) oder die anderen Leistungstransistoren (M1, M2, M3, M4, M5, M6) mittels des verwendeten Steuerwertes (lg1, lg2, Ig3, Vg1', Vg2', Vg3') so angesteuert wird/werden, dass seine/ihre Gatespannung (Vg) zumindest solange unterhalb der Schwellspannung (V_TH) bleibt, bis die Gatespannung (Vg) des ersten Leistungstransistors (M1, M2, M3, M4, M5, M6) ein Millerplateau (Vg_PLAT) erreicht hat.

3. Verfahren nach Anspruch 1 oder 2, wobei bei einer Ausschaltsequenz der parallel geschalteten Leistungstransistoren (M1, M2, M3, M4, M5, M6) ein erster der Leistungstransistoren (M1, M2, M3, M4, M5, M6) zunächst mit einem niedrigeren Steuerwert (lg1, lg2, Ig3, Vg1', Vg2', Vg3') angesteuert wird als der andere Leistungstransistor (M1, M2, M3, M4, M5, M6) oder die anderen Leistungstransistoren (M1, M2, M3, M4, M5, M6), so dass eine Gatespannung (Vg) des ersten Leistungstransistors (M1, M2, M3, M4, M5, M6) ein Millerplateau (Vg_PLAT) als letztes erreicht, wobei die einander parallel geschalteten Leistungstransistoren (M1, M2, M3, M4, M5, M6) über aufeinanderfolgende Pulsweitenmodulationstaktperioden in der Ausschaltsequenz alternierend als erster Leistungstransistor (M1, M2, M3, M4, M5, M6) zunächst mit einem niedrigeren Steuerwert (lg1, lg2, Ig3, Vg1', Vg2', Vg3') angesteuert werden.

4. Verfahren nach einem der vorhergehenden Ansprüche, wobei als Steuerwert (lg1, lg2, Ig3, Vg1', Vg2', Vg3') ein Gatestrom (Ig) oder eine Gatespannungsänderungsrate (Vg') verwendet wird.

5. Verfahren nach Anspruch 3 oder 4, wobei innerhalb jeweils einer der Pulsweitenmodulationstaktperioden einer der Leistungstransistoren (M1, M2, M3, M4, M5, M6) sowohl in der Einschaltsequenz als erster Leistungstransistor (M1, M2, M3, M4, M5, M6) zunächst mit einem höheren Steuerwert (lg1, lg2, Ig3, Vg1', Vg2', Vg3') angesteuert wird als auch in der Ausschaltsequenz als erster Leistungstransistor (M1, M2, M3, M4, M5, M6) zunächst mit einem niedrigeren Steuerwert (lg1, lg2, Ig3, Vg1', Vg2', Vg3') angesteuert wird.

6. Verfahren nach Anspruch 3 oder 4, wobei innerhalb jeweils einer der Pulsweitenmodulationstaktperioden einer der Leistungstransistoren (M1, M2, M3, M4, M5, M6) in der Einschaltsequenz als erster Leistungstransistor (M1, M2, M3, M4, M5, M6) zunächst mit einem höheren Steuerwert (lg1, lg2, Ig3, Vg1', Vg2', Vg3') angesteuert wird und in der Ausschaltsequenz ein anderer der Leistungstransistoren (M1, M2, M3, M4, M5, M6) als erster Leistungstransistor (M1, M2, M3, M4, M5, M6) zunächst mit einem niedrigeren Steuerwert (lg1, lg2, Ig3, Vg1', Vg2', Vg3') angesteuert wird.

7. Verfahren nach einem der Ansprüche 2 bis 6, wobei in der Einschaltsequenz bei Überschreiten eines vorgegebenen Wertes (Vg_PLAT_2ND) und bis zum Erreichen des Millerplateaus (Vg_PLAT) durch die Gatespannung (Vg) des ersten Leistungstransistors (M1, M2, M3, M4, M5, M6) der erste Leistungstransistor (M1, M2, M3, M4, M5, M6) mit einem niedrigeren Steuerwert (lg1, lg2, Ig3, Vg1', Vg2', Vg3') angesteuert wird als der andere Leistungstransistor (M1, M2, M3, M4, M5, M6) oder die anderen Leistungstransistoren (M1, M2, M3, M4, M5, M6), wobei die Steuerwerte (Ig1, lg2, Ig3, Vg1', Vg2', Vg3') aller einander parallel geschalteter Leistungstransistoren (M1, M2, M3, M4, M5, M6) anschließend angehoben werden.

8. Verfahren nach einem der Ansprüche 3 bis 7, wobei in der Ausschaltsequenz bei oder kurz vor dem Abfall der Gatespannung (Vg) des anderen Leistungstransistors (M1, M2, M3, M4, M5, M6) oder der anderen Leistungstransistoren (M1, M2, M3, M4, M5, M6) auf Null die Gatespannung (Vg) des ersten Leistungstransistors (M1, M2, M3, M4, M5, M6) auf einen niedrigeren Steuerwert (lg1, lg2, Ig3, Vg1', Vg2', Vg3') abgesenkt und die Gatespannung (Vg) des anderen Leistungstransistors (M1, M2, M3, M4, M5, M6) oder der anderen Leistungstransistoren (M1, M2, M3, M4, M5, M6) auf Null abgesenkt wird.

9. Verfahren nach einem der vorhergehenden Ansprüche, wobei die Ansteuerung der Gates mittels eines ASIC erfolgt.

## Claims

1. Method for switching a cycle in a power transistor circuit (HB1, HB2, HB3) comprising at least two power transistors (M1, M2, M3, M4, M5, M6) connected in parallel with one another, wherein the power transistors (M1, M2, M3, M4, M5, M6) each comprise a gate, which during the method are driven with at least three control values (Ig1, Ig2, Ig3, Vg1', Vg2', Vg3') which are different from one another and different from zero, **characterized in that** during a switch-on sequence of the power transistors (M1, M2, M3, M4, M5, M6) connected in parallel, a first of the power transistors (M1, M2, M3, M4, M5, M6) is firstly driven with a higher control value (Ig1, Ig2, Ig3, Vgl `, Vg2', Vg3') than the other power transistor (M1, M2, M3, M4, M5, M6) or the other power transistors (M1, M2, M3, M4, M5, M6), such that a gate voltage (Vg) of the first power transistor (M1, M2, M3, M4, M5, M6) is the first to exceed a threshold voltage (V_TH), and **in that** the power transistors (M1, M2, M3, M4, M5, M6) connected in parallel with one another are firstly driven with a higher control value (Ig1, Ig2, Ig3, Vg1', Vg2', Vg3') alternately as first power transistor (M1, M2, M3, M4, M5, M6) over successive pulse width modulation clock periods in the switch-on sequence.

2. Method according to Claim 1, wherein the other power transistor (M1, M2, M3, M4, M5, M6) or the other power transistors (M1, M2, M3, M4, M5, M6) is/are driven by means of the control value (Ig1, Ig2, Ig3, Vg1', Vg2', Vg3') used such that its/their gate voltage (Vg) remains below the threshold voltage (V_TH) at least until the gate voltage (Vg) of the first power transistor (M1, M2, M3, M4, M5, M6) has reached a Miller plateau (Vg_PLAT).

3. Method according to Claim 1 or 2, wherein during a switch-off sequence of the power transistors (M1, M2, M3, M4, M5, M6) connected in parallel, a first of the power transistors (M1, M2, M3, M4, M5, M6) is firstly driven with a lower control value (Ig1, Ig2, Ig3, Vg1', Vg2', Vg3') than the other power transistor (M1, M2, M3, M4, M5, M6) or the other power transistors (M1, M2, M3, M4, M5, M6), such that a gate voltage (Vg) of the first power transistor (M1, M2, M3, M4, M5, M6) is the last to reach a Miller plateau (Vg_PLAT), wherein the power transistors (M1, M2, M3, M4, M5, M6) connected in parallel with one another are firstly driven with a lower control value (Ig1, Ig2, Ig3, Vgl `, Vg2', Vg3') alternately as first power transistor (M1, M2, M3, M4, M5, M6) over successive pulse width modulation clock periods in the switch-off sequence.

4. Method according to any of the preceding claims, wherein a gate current (Ig) or a gate voltage change rate (Vg`) is used as control value (Ig1, Ig2, Ig3, Vg1', Vg2', Vg3').

5. Method according to Claim 3 or 4, wherein within a respective one of the pulse width modulation clock periods one of the power transistors (M1, M2, M3, M4, M5, M6) both in the switch-on sequence is firstly driven with a higher control value (Ig1, Ig2, Ig3, Vg1', Vg2', Vg3') as first power transistor (M1, M2, M3, M4, M5, M6) and in the switch-off sequence is firstly driven with a lower control value (Ig1, Ig2, Ig3, Vg1', Vg2', Vg3') as first power transistor (M1, M2, M3, M4, M5, M6).

6. Method according to Claim 3 or 4, wherein within a respective one of the pulse width modulation clock periods one of the power transistors (M1, M2, M3, M4, M5, M6) is firstly driven with a higher control value (Ig1, Ig2, Ig3, Vg1', Vg2', Vg3') as first power transistor (M1, M2, M3, M4, M5, M6) in the switch-on sequence and another of the power transistors (M1, M2, M3, M4, M5, M6) is firstly driven with a lower control value (Ig1, Ig2, Ig3, Vg1', Vg2', Vg3') as first power transistor (M1, M2, M3, M4, M5, M6) in the switch-off sequence.

7. Method according to any of Claims 2 to 6, wherein in the switch-on sequence, when a predefined value (Vg_PLAT_2ND) is exceeded and until the Miller plateau (Vg_PLAT) is reached by the gate voltage (Vg) of the first power transistor (M1, M2, M3, M4, M5, M6), the first power transistor (M1, M2, M3, M4, M5, M6) is driven with a lower control value (Ig1, Ig2, Ig3, Vgl `, Vg2', Vg3') than the other power transistor (M1, M2, M3, M4, M5, M6) or the other power transistors (M1, M2, M3, M4, M5, M6), wherein the control values (Ig1, Ig2, Ig3, Vg1', Vg2', Vg3`) of all the power transistors (M1, M2, M3, M4, M5, M6) connected in parallel with one another are subsequently increased.

8. Method according to any of Claims 3 to 7, wherein in the switch-off sequence, when or shortly before the gate voltage (Vg) of the other power transistor (M1, M2, M3, M4, M5, M6) or of the other power transistors (M1, M2, M3, M4, M5, M6) falls to zero, the gate voltage (Vg) of the first power transistor (M1, M2, M3, M4, M5, M6) is decreased to a lower control value (Ig1, Ig2, Ig3, Vg1', Vg2', Vg3') and the gate voltage (Vg) of the other power transistor (M1, M2, M3, M4, M5, M6) or of the other power transistors (M1, M2, M3, M4, M5, M6) is decreased to zero.

9. Method according to any of the preceding claims, wherein the gates are driven by means of an ASIC.

## Revendications

1. Procédé de commutation d'un cycle dans un circuit de transistors de puissance (HB1, HB2, HB3), lequel possède au moins deux transistors de puissance (M1, M2, M3, M4, M5, M6) montés en parallèle les uns avec les autres, les transistors de puissance (M1, M2, M3, M4, M5, M6) possédant chacun une grille qui, lors du procédé, est commandée par au moins trois valeurs de commande (Ig1, Ig2, Ig3, Vg1', Vg2', Vg3') différentes les unes des autres et de zéro, **caractérisé en ce que**, lors d'une séquence de mise en circuit des transistors de puissance (M1, M2, M3, M4, M5, M6) montés en parallèle, un premier des transistors de puissance (M1, M2, M3, M4, M5, M6) est tout d'abord commandé avec une valeur de commande (Ig1, Ig2, Ig3, Vg1', Vg2', Vg3') plus élevée que l'autre transistor de puissance (M1, M2, M3, M4, M5, M6) ou les autres transistors de puissance (M1, M2, M3, M4, M5, M6), de sorte qu'une tension de grille (Vg) du premier transistor de puissance (M1, M2, M3, M4, M5, M6) dépasse la première une tension de seuil (V_TH), et **en ce que** les transistors de puissance (M1, M2, M3, M4, M5, M6) montés en parallèle les uns avec les autres sont commandés sur des périodes d'horloge de modulation de largeur d'impulsion successives dans la séquence de mise en circuit en alternance en tant que premier transistor de puissance (M1, M2, M3, M4, M5, M6) tout d'abord avec une valeur de commande (Ig1, Ig2, Ig3, Vg1', Vg2', Vg3') plus élevée.

2. Procédé selon la revendication 1, l'autre transistor de puissance (M1, M2, M3, M4, M5, M6) ou les autres transistors de puissance (M1, M2, M3, M4, M5, M6) étant commandé(s) au moyen de la valeur de commande (Ig1, Ig2, Ig3, Vg1', Vg2', Vg3') utilisée de manière à ce que sa/leur tension de grille (Vg) reste inférieure à la tension de seuil (V_TH) au moins jusqu'à ce que la tension de grille (Vg) du premier transistor de puissance (M1, M2, M3, M4, M5, M6) ait atteint un plateau de Miller (Vg_PLAT).

3. Procédé selon la revendication 1 ou 2, avec lequel, lors d'une séquence de mise hors circuit des transistors de puissance (M1, M2, M3, M4, M5, M6) montés en parallèle, un premier des transistors de puissance (M1, M2, M3, M4, M5, M6) est tout d'abord commandé avec une valeur de commande (Ig1, Ig2, Ig3, Vg1', Vg2', Vg3') inférieure à celle de l'autre transistor de puissance (M1, M2, M3, M4, M5, M6) ou des autres transistors de puissance (M1, M2, M3, M4, M5, M6), de sorte qu'une tension de grille (Vg) du premier transistor de puissance (M1, M2, M3, M4, M5, M6) atteint un plateau de Miller (Vg_PLAT) en dernier, les transistors de puissance (M1, M2, M3, M4, M5, M6) montés en parallèle les uns avec les autres étant commandés sur des périodes d'horloge de modulation de largeur d'impulsion successives dans la séquence de mise hors circuit en alternance en tant que premier transistor de puissance (M1, M2, M3, M4, M5, M6), tout d'abord avec une valeur de commande (Ig1, Ig2, Ig3, Vg1', Vg2', Vg3') plus faible.

4. Procédé selon l'une des revendications précédentes, la valeur de commande (Ig1, Ig2, Ig3, Vg1', Vg2', Vg3') utilisée étant un courant de grille (Ig) ou un taux de variation de tension de grille (Vg').

5. Procédé selon la revendication 3 ou 4, avec lequel, à l'intérieur de l'une respective des périodes d'horloge de modulation de largeur d'impulsion, l'un des transistors de puissance (M1, M2, M3, M4, M5, M6) est commandé à la fois dans la séquence de mise en circuit en tant que premier transistor de puissance (M1, M2, M3, M4, M5, M6) tout d'abord avec une valeur de commande (Ig1, Ig2, Ig3, Vg1', Vg2', Vg3') plus élevée, et commandé à la fois dans la séquence de mise hors circuit en tant que premier transistor de puissance (M1, M2, M3, M4, M5, M6) tout d'abord avec une valeur de commande (Ig1, Ig2, Ig3, Vg1', Vg2', Vg3') plus faible.

6. Procédé selon la revendication 3 ou 4, avec lequel, à l'intérieur de l'une respective des périodes d'horloge de modulation de largeur d'impulsion, l'un des transistors de puissance (M1, M2, M3, M4, M5, M6) est commandé dans la séquence de mise en circuit en tant que premier transistor de puissance (M1, M2, M3, M4, M5, M6) tout d'abord avec une valeur de commande (Ig1, Ig2, Ig3, Vg1', Vg2', Vg3') plus élevée et, dans la séquence de mise hors circuit, un autre des transistors de puissance (M1, M2, M3, M4, M5, M6) est commandé en tant que premier transistor de puissance (M1, M2, M3, M4, M5, M6) tout d'abord avec une valeur de commande (Ig1, Ig2, Ig3, Vg1', Vg2', Vg3') plus faible.

7. Procédé selon l'une des revendications 2 à 6, avec lequel, dans la séquence de mise en circuit, en cas de dépassement d'une valeur prédéterminée (Vg_PLAT_2ND) et jusqu'à ce que le plateau de Miller (Vg_PLAT) soit atteint par la tension de grille (Vg) du premier transistor de puissance (M1, M2, M3, M4, M5, M6), le premier transistor de puissance (M1, M2, M3, M4, M5, M6) est commandé avec une valeur de commande (Ig1, Ig2, Ig3, Vg1', Vg2', Vg3') plus faible que l'autre transistor de puissance (M1, M2, M3, M4, M5, M6) ou les autres transistors de puissance (M1, M2, M3, M4, M5, M6), les valeurs de commande (Ig1, Ig2, Ig3, Vg1', Vg2', Vg3') de tous les transistors de puissance (M1, M2, M3, M4, M5, M6) montés en parallèle les uns avec les autres étant ensuite augmentées.

8. Procédé selon l'une des revendications 3 à 7, avec lequel, dans la séquence de mise hors tension, lors de la chute à zéro de la tension de grille (Vg) de l'autre transistor de puissance (M1, M2, M3, M4, M5, M6) ou des autres transistors de puissance (M1, M2, M3, M4, M5, M6) ou peu de temps avant, la tension de grille (Vg) du premier transistor de puissance (M1, M2, M3, M4, M5, M6) est abaissée à une valeur de commande (Ig1, Ig2, Ig3, Vg1', Vg2', Vg3') plus faible et la tension de grille (Vg) de l'autre transistor de puissance (M1, M2, M3, M4, M5, M6) ou des autres transistors de puissance (M1, M2, M3, M4, M5, M6) est abaissée à zéro.

9. Procédé selon l'une des revendications précédentes, la commande des grilles étant effectuée au moyen d'un ASIC.
